# EUROPEAN PATENT APPLICATION

(11) **EP 4 804 396 A1**
(43) Date of publication of application: **09.09.2026**
(21) Application number: 24896367.0
(22) Date of filing: 20.11.2024
(51) Int. Cl.: H02M 7/483, H02M 7/5387, H02M 1/00, H02J 3/00

(54) **POWER CONVERTER AND POWER SUPPLY SYSTEM**

(30) Priority: 27.11.2023 CN 202311611863
(71) Applicant: Huawei Digital Power Technologies Co., Ltd., Shenzhen, Guangdong 518043 (CN)
(72) Inventor: YU, Xinyu, Shenzhen, Guangdong 518043 (CN); XIN, Kai, Shenzhen, Guangdong 518043 (CN); ZHAN, Jinxiang, Shenzhen, Guangdong 518043 (CN); DONG, Mingxuan, Shenzhen, Guangdong 518043 (CN)
(74) Representative: Isarpatent
(86) International application number: PCT/CN2024/133223
(87) International publication number: WO 2025/113276

(57) **Abstract**

This application provides a power converter, including a power conversion circuit and a control circuit. The power conversion circuit includes an inverter circuit, a direct current busbar capacitor, and a detection circuit. The direct current busbar capacitor is connected in parallel to the inverter circuit. The direct current busbar capacitor includes a positive busbar capacitor and a negative busbar capacitor that are connected in series. The inverter circuit includes a bridge arm. The detection circuit is configured to detect a voltage between both sides of the positive busbar capacitor, a voltage between both sides of the negative busbar capacitor, and an output current of the bridge arm. The control circuit is configured to: in response to a preset condition, control the bridge arm to switch from outputting two levels to outputting three levels in one switching cycle. The preset condition is a condition based on the voltage of the positive busbar capacitor, the voltage of the negative busbar capacitor, and the output current of the bridge arm. **In** this application, three-level and two-level hybrid modulation is used, so that the power converter may achieve a balance between electric energy output quality and power consumption, thereby improving performance of the power converter.

## Description

This application claims priority to Chinese Patent Application No. 202311611863.8, filed with the China National Intellectual Property Administration on November 27, 2023 and entitled "POWER CONVERTER AND POWER SUPPLY SYSTEM", which is incorporated herein by reference in its entirety.

### TECHNICAL FIELD

This application relates to the circuit field, and more specifically, to a power converter and a power supply system.

### BACKGROUND

Power converters are widely used in power systems. A power converter may be controlled by using bipolar modulation, that is, a bridge arm in the power converter may be controlled to output three levels: a forward level, a reverse level, and a zero level in one switching cycle to be fitted into a sinusoidal alternating current, to improve quality of electric energy. When the zero level is output, currents flowing into positive and negative busbar capacitors in the power converter are different, and consequently, positive and negative direct current busbar voltages of the power converter are unbalanced. Because the three levels are output during bipolar modulation, short duration of the zero level may be reduced, and impact on the positive and negative direct current busbar voltages may be reduced, so that a degree of imbalance between the positive and negative direct current busbar voltages is within a tolerance range, thereby ensuring that the power converter may normally run.

However, when bipolar modulation is used, the bridge arm needs to output the three levels in one switching cycle, and this causes an increase in power consumption due to frequent switching of a switching transistor on the bridge arm in the power converter. To reduce power consumption, unipolar modulation is proposed to control the power converter, that is, the bridge arm in the power converter may be controlled to output two levels: the forward level and the zero level in one switching cycle to be fitted into a sinusoidal alternating current. However, when unipolar modulation is used, the duration of the zero level is increased, and the degree of imbalance between the positive and negative direct current busbar voltages is increased. In a serious case, the positive and negative direct current busbar voltages are significantly uneven, thereby affecting running efficiency of the power converter.

Therefore, how to reduce power consumption of the power converter when the degree of imbalance between the positive and negative direct current busbar voltages is within the tolerance range becomes an urgent problem to be resolved.

### SUMMARY

This application provides a power converter. A bridge arm in a power conversion circuit is controlled to output three levels or two levels, so that a middle point voltage of the power conversion circuit in the power converter remains balanced, quality of output electric energy is improved, and power consumption of the power converter is reduced.

According to a first aspect, a power converter is provided. A positive electrode of a direct current side of the power converter is configured to connect to a positive direct current busbar, a negative electrode of the direct current side is configured to connect to a negative direct current busbar, and the power converter includes a power conversion circuit, a filter circuit, and a control circuit. The power conversion circuit includes an inverter circuit and a direct current busbar capacitor, and the direct current busbar capacitor is connected between the positive direct current busbar and the negative direct current busbar. The inverter circuit includes at least one bridge arm, an output end of each bridge arm is electrically connected to the filter circuit, each bridge arm includes a plurality of switching transistors, and the bridge arm is configured to convert an input direct current into an alternating current. The control circuit is configured to control, based on a voltage between both sides of a positive busbar capacitor, a voltage between both sides of a negative busbar capacitor, and an output current of a bridge arm in the at least one bridge arm, the bridge arm to switch between a first modulation mode and a second modulation mode. In the first modulation mode, a level output by any bridge arm in one switching cycle includes a co-directional level, a zero level, and a reverse level; and in the second modulation mode, a level output by any bridge arm in one switching cycle includes the co-directional level and the zero level. The co-directional level is a level in a direction that is the same as a direction of an equivalent voltage output by the inverter circuit, and the reverse level is a level in a direction that is opposite to the direction of the equivalent voltage output by the inverter circuit.

It should be noted that, in this application, the direct current busbar capacitor includes a positive busbar capacitor and a negative busbar capacitor. The positive busbar capacitor is connected to the positive direct current busbar, the negative busbar capacitor is connected to the negative direct current busbar, and the positive busbar capacitor and the negative busbar capacitor are connected in series.

In this application, the bridge arm may output three levels and two levels in a hybrid manner, and the output levels may be fitted into an alternating current after passing through a subsequent filter circuit and the like. Compared with purely outputting two levels, the bridge arm in this application may reduce a time for outputting the zero level, and reduce imbalance between positive and negative busbar voltages caused by the zero level. In addition, effect of fitting three levels into an alternating current is better than effect of fitting two levels into an alternating current, so that quality of output electric energy may be improved. Compared with purely outputting three levels, the bridge arm in this application may reduce switching frequency of the switching transistors, thereby reducing power consumption of the switching transistors, and enabling the circuit to achieve a balance between electric energy quality and power consumption.

A voltage difference between the positive busbar capacitor and the negative busbar capacitor and the output current of the bridge arm are considered, so that a balance of a middle point voltage of the power conversion circuit may be ensured, and stability of the power converter may be improved.

With reference to the first aspect, in some implementations of the first aspect, the control circuit is specifically configured to: in response to a preset condition being met, control the bridge arm to switch from the second modulation mode to the first modulation mode.

The preset condition includes any one of the following conditions: ${V}_{+} - {V}_{-} \geq {V}_{limit 1} > 0 and 0 < {I}_{limit 1} \leq I \leq {I}_{limit 2} ;$ ${V}_{+} - {V}_{-} \geq {V}_{limit 1} > 0 and {I}_{limit 3} \leq I \leq {I}_{limit 4} < 0 ;$ ${V}_{+} - {V}_{-} \leq {V}_{limit 2} < 0 and 0 < {I}_{limit 1} \leq I \leq {I}_{limit 2} ;$ and ${V}_{+} - {V}_{-} \leq {V}_{limit 2} < 0 and {I}_{limit 3} \leq I \leq {I}_{limit 4} < 0 .$

*V*₊ represents the voltage between both ends of the positive busbar capacitor, *V*₋ represents the voltage between both ends of the negative busbar capacitor, I represents the output current of the bridge arm, *V*_{*limit*1} represents a preset first voltage threshold, *V*_{*limit*2} represents a preset second voltage threshold, *I*_{*limit*1} represents a preset first current threshold, *I*_{*limit*2} represents a preset second current threshold, *I*_{*limit*3} represents a preset third current threshold, and *I*_{*limit*4} represents a preset fourth current threshold.

In this application, a degree of imbalance between the positive and negative busbar voltages is determined based on the voltage difference between the positive busbar capacitor and the negative busbar capacitor and the output current of the bridge arm. When the imbalance degree exceeds presetting, the first modulation mode is used to reduce duration of the zero level, so that the balance of the middle point voltage of the power conversion circuit may be ensured, and the stability of the power converter may be improved. When the imbalance degree exceeds the presetting, the second modulation mode is used to reduce the switching frequency of the switching transistors, so that power consumption of the switching transistors may be reduced.

With reference to the first aspect, in some implementations of the first aspect, in the first modulation mode: ${t}_{1} > {t}_{2} ;$ and ${t}_{3} < {t}_{4} .$
*t*₁ represents duration in which the bridge arm outputs the reverse level in one switching cycle when the condition 1 is met, *t*₂ represents duration in which the bridge arm outputs the reverse level in one switching cycle when the condition 2 is met, *t*₃ represents duration in which the bridge arm outputs the reverse level in one switching cycle when the condition 3 is met, and *t*₄ represents duration in which the bridge arm outputs the reverse level in one switching cycle when the condition 4 is met.

In the condition 1 and the condition 2, the voltage between both ends of the positive busbar capacitor is greater than the voltage between both ends of the negative busbar capacitor, and charging of the positive busbar capacitor needs to be reduced, or discharging of the positive busbar capacitor needs to be increased. In the condition 1, because the output current of the bridge arm is positive, outputting the reverse level by the bridge arm is equivalent to discharging the positive busbar capacitor. In the condition 2, because the output current of the bridge arm is positive, outputting the reverse level by the bridge arm is equivalent to charging the positive busbar capacitor. When duration of outputting the reverse level in the condition 1 is greater than duration of outputting the reverse level in the condition 2, charging of the positive busbar capacitor may be reduced, or discharging of the positive busbar capacitor may be increased, thereby reducing the voltage difference between the voltage between both ends of the positive busbar capacitor and the voltage between both ends of the negative busbar capacitor, and improving stability of the inverter circuit. Flexibility of the inverter circuit may be improved by properly adjusting the duration of the reverse level in different conditions.

With reference to the first aspect, in some implementations of the first aspect, the control circuit is specifically configured to: in response to a preset condition being met, control the bridge arm to switch from the second modulation mode to the first modulation mode.

The preset condition includes any one of the following conditions: ${V}_{+} - {V}_{-} \geq {V}_{limit 3} > 0 and 0 < {I}_{limit 5} \leq I \leq {I}_{limit 6} ;$ and ${V}_{+} - {V}_{-} \leq {V}_{limit 4} < 0 and {I}_{limit 7} \leq I \leq {I}_{limit 8} < 0 .$

*V*₊ represents the voltage between both ends of the positive busbar capacitor, *V*₋ represents the voltage between both ends of the negative busbar capacitor, I represents the output current of the bridge arm, *V*_{*limit*3} represents a preset third voltage threshold, *V*_{*limit*4} represents a preset fourth voltage threshold, *I*_{*limit*5} represents a preset fifth current threshold, *I*_{*limit*6} represents a preset sixth current threshold, *I_{límít7}* represents a preset seventh current threshold, and *I*_{*limit*8} represents a preset eighth current threshold.

In the foregoing solution, a case in which the first modulation mode is used is reduced, and a proportion of the first modulation mode is reduced, so that the switching frequency of the switching transistors may be reduced, and power consumption of the switching transistors may be reduced.

With reference to the first aspect, in some implementations of the first aspect, the power converter further includes a detection circuit, and the detection circuit is configured to detect the voltage between both sides of the positive busbar capacitor, the voltage between both sides of the negative busbar capacitor, and the output current of the bridge arm.

Based on the foregoing solution, the voltage between both sides of the positive busbar capacitor, the voltage between both sides of the negative busbar capacitor, and the output current of the bridge arm may be obtained by using the detection circuit, thereby ensuring that the power converter may obtain a parameter in a timely and accurate manner.

According to a second aspect, a control method is provided. The control method is applied to a power converter. A positive electrode of a direct current side of the power converter is configured to connect to a positive direct current busbar, a negative electrode of the direct current side is configured to connect to a negative direct current busbar, and the power converter includes a power conversion circuit, a filter circuit, and a control circuit. The power conversion circuit includes an inverter circuit and a direct current busbar capacitor, and the direct current busbar capacitor is connected between the positive direct current busbar and the negative direct current busbar. The inverter circuit includes at least one bridge arm, an output end of each bridge arm is electrically connected to the filter circuit, each bridge arm includes a plurality of switching transistors, and the bridge arm is configured to convert an input direct current into an alternating current.

The control method includes: obtaining a voltage between both sides of a positive busbar capacitor, a voltage between both sides of a negative busbar capacitor, and an output current of each bridge arm; and controlling, based on the voltage between both sides of the positive busbar capacitor, the voltage between both sides of the negative busbar capacitor, and an output current of a bridge arm in the at least one bridge arm, the bridge arm to switch between a first modulation mode and a second modulation mode. In the first modulation mode, a level output by the bridge arm in one switching cycle includes a co-directional level, a zero level, and a reverse level. In the second modulation mode, a level output by the bridge arm in one switching cycle includes the co-directional level and the zero level. The co-directional level is a level in a direction that is the same as a direction of an equivalent voltage output by the inverter circuit, and the reverse level is a level in a direction that is opposite to the direction of the equivalent voltage output by the inverter circuit.

With reference to the second aspect, in some implementations of the second aspect, the method includes: in response to a preset condition being met, controlling the bridge arm to switch from the second modulation mode to the first modulation mode.

The preset condition includes any one of the following conditions: ${V}_{+} - {V}_{-} \geq {V}_{limit 1} > 0 and 0 < {I}_{limit 1} \leq I \leq {I}_{limit 2} ;$ ${V}_{+} - {V}_{-} \geq {V}_{limit 1} > 0 and {I}_{limit 3} \leq I \leq {I}_{limit 4} < 0 ;$ ${V}_{+} - {V}_{-} \leq {V}_{limit 2} < 0 and 0 < {I}_{limit 1} \leq I \leq {I}_{limit 2} ;$ and ${V}_{+} - {V}_{-} \leq {V}_{limit 2} < 0 and {I}_{limit 3} \leq I \leq {I}_{limit 4} < 0 .$

*V*₊ represents the voltage between both ends of the positive busbar capacitor, *V*₋ represents the voltage between both ends of the negative busbar capacitor, I represents the output current of the bridge arm, *V*_{*limit*1} represents a preset first voltage threshold, *V*_{*limit*2} represents a preset second voltage threshold, *I*_{*limit*1} represents a preset first current threshold, *I*_{*limit*2} represents a preset second current threshold, *I*_{*limit*3} represents a preset third current threshold, and *I*_{*limit*4} represents a preset fourth current threshold.

With reference to the second aspect, in some implementations of the second aspect, in the first modulation mode: ${t}_{1} > {t}_{2} ;$ and ${t}_{3} < {t}_{4} .$
*t*₁ represents duration in which the bridge arm outputs the reverse level in one switching cycle when the condition 1 is met, *t*₂ represents duration in which the bridge arm outputs the reverse level in one switching cycle when the condition 2 is met, *t*₃ represents duration in which the bridge arm outputs the reverse level in one switching cycle when the condition 3 is met, and *t*₄ represents duration in which the bridge arm outputs the reverse level in one switching cycle when the condition 4 is met.

With reference to the second aspect, in some implementations of the second aspect, the method includes: in response to a preset condition being met, controlling the bridge arm to switch from the second modulation mode to the first modulation mode.

The preset condition includes any one of the following conditions: ${V}_{+} - {V}_{-} \geq {V}_{limit 3} > 0 and 0 < {I}_{limit 5} \leq I \leq {I}_{limit 6} ;$ and ${V}_{+} - {V}_{-} \leq {V}_{limit 4} < 0 and {I}_{limit 7} \leq I \leq {I}_{limit 8} < 0 .$

*V*₊ represents the voltage between both ends of the positive busbar capacitor, *V*₋ represents the voltage between both ends of the negative busbar capacitor, I represents the output current of the bridge arm, *V*_{*limit*3} represents a preset third voltage threshold, *V*_{*limit*4} represents a preset fourth voltage threshold, *I*_{*limit*6} represents a preset fifth current threshold, *I*_{*limit*6} represents a preset sixth current threshold, *I_{límít7}* represents a preset seventh current threshold, and *I*_{*limit*8} represents a preset eighth current threshold.

With reference to the second aspect, in some implementations of the second aspect, the method further includes: obtaining, from a detection circuit, the voltage between both sides of the positive busbar capacitor, the voltage between both sides of the negative busbar capacitor, and the output current of the bridge arm. The detection circuit is configured to detect the voltage between both sides of the positive busbar capacitor, the voltage between both sides of the negative busbar capacitor, and the output current of the bridge arm.

For beneficial effects of the second aspect and the implementations of the second aspect, refer to the descriptions of the first aspect and the implementations of the first aspect. Details are not described herein again.

According to a third aspect, a power supply system is provided, including: a power supply, a positive busbar, a negative busbar, and at least one power converter according to the first aspect and the possible implementations of the first aspect. The power supply is connected to a positive input end of the power converter by using the positive busbar, and is connected to a negative input end of the power converter by using the negative busbar. The power converter is configured to convert a direct current input by the power supply into an alternating current, and output the alternating current to a load.

With reference to the third aspect, in some implementations of the third aspect, the power supply includes a photovoltaic power generation device and/or an energy storage device.

For beneficial effects of the third aspect and the implementations of the third aspect, refer to the descriptions of the first aspect and the implementations of the first aspect. Details are not described herein again.

### BRIEF DESCRIPTION OF DRAWINGS

FIG. 1 is a diagram of an application scenario according to an embodiment of this application;
FIG. 2 is a schematic of a topology of a three-phase power conversion circuit according to an embodiment of this application;
FIG. 3 is a schematic of a topology of a power conversion circuit according to an embodiment of this application;
FIG. 4 is a schematic of a topology of another power conversion circuit according to an embodiment of this application;
FIG. 5 is a schematic of a topology of still another power conversion circuit according to an embodiment of this application;
FIG. 6 is a sequence diagram of a switching transistor on a bridge arm during unipolar modulation according to an embodiment of this application;
FIG. 7 is a sequence diagram of a switching transistor on a bridge arm during bipolar modulation according to an embodiment of this application;
FIG. 8 is a diagram of a power converter according to an embodiment of this application;
FIG. 9 is a diagram of a control method according to an embodiment of this application;
FIG. 10 is a control logic diagram of a control circuit according to an embodiment of this application;
FIG. 11 is another control logic diagram of a control circuit according to an embodiment of this application;
FIG. 12 is a sequence diagram according to an embodiment of this application; and
FIG. 13 is a simulated voltage diagram according to an embodiment of this application.

### DESCRIPTION OF EMBODIMENTS

The following describes technical solutions of this application with reference to accompanying drawings.

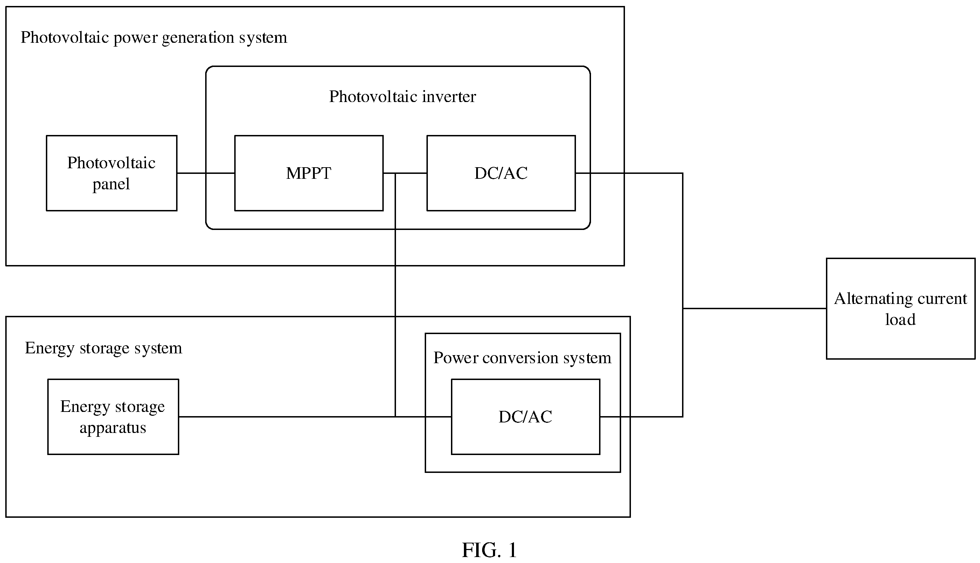

FIG. 1 is a diagram of an application scenario according to an embodiment of this application. As shown in FIG. 1, a photovoltaic power generation system includes a photovoltaic (photovoltaic, PV) module and a photovoltaic inverter. The photovoltaic module converts solar energy into electric energy. Because the photovoltaic module generates a direct current, the direct current needs to be converted into an alternating current by using the photovoltaic inverter, to facilitate power transmission and utilization.

The photovoltaic inverter includes a direct current to alternating current (direct current to alternating current, DC/AC) converter, and the DC/AC converter is configured to convert a direct current into an alternating current.

The photovoltaic inverter further includes a maximum power point tracking (maximum power point tracking, MPPT) module. The MPPT module is configured to track a maximum voltage value and a maximum current value, so that the power generation system outputs a current at maximum power.

The MPPT module and the DC/AC converter in the photovoltaic inverter may be disposed in a same packaged device, or may be disposed in different packaged devices.

The MPPT module may include a direct current to direct current (direct current to direct current, DC/DC) converter. The DC/DC converter is configured to perform voltage stabilization (or voltage conversion) on a direct current generated by the PV module. A direct current obtained through voltage stabilization may be output to a power system.

One end of the DC/AC converter in the photovoltaic inverter is connected to the MPPT module and an energy storage system, and the other end is configured to connect to an alternating current load, so that the DC/AC converter converts a direct current output by the MPPT module or the energy storage system into an alternating current, and supplies the alternating current to a power grid or the alternating current load.

The energy storage system includes an energy storage apparatus and a power conversion system (power conversion system, PCS). The energy storage apparatus includes one or more battery clusters and one or more battery management systems (battery management system, BMS), and each battery cluster corresponds to one BMS. The BMS is usually configured to implement functions such as dynamic monitoring of charging and discharging of a battery, battery balancing, and state of charge evaluation of the battery.

In this embodiment of this application, the energy storage apparatus includes one or more battery clusters, and when the energy storage apparatus includes a plurality of battery clusters, the plurality of battery clusters are connected in parallel. A plurality of battery packs form a battery cluster. Each battery pack includes one or more packs (PACK). In an implementation, each battery pack may further include a battery management unit (battery management unit, BMU), and the energy storage apparatus further includes a battery control unit (battery control unit, BCU). The BMS includes the BMU and the BCU. The BMU is configured to monitor information such as a voltage and a temperature of the pack, and report the information to the BCU. The BCU monitors the pack based on the information, and generates a power control instruction for the pack.

Because the energy storage apparatus stores a direct current, the direct current needs to be converted into an alternating current by using the PCS, to facilitate power transmission and utilization. The PCS includes a DC/AC converter, and the DC/AC converter is configured to convert a direct current into an alternating current.

A power converter provided in embodiments of this application may be used in any independent system in the photovoltaic power generation system or the energy storage system, or may be used in a photovoltaic energy storage system, that is, an integrated system of the photovoltaic power generation system and the energy storage system. It should be understood that the photovoltaic inverter and the PCS in the foregoing scenario are merely examples of the power converter. The power converter in embodiments of this application may further include another device configured to perform power conversion, for example, a filter. This is not limited.

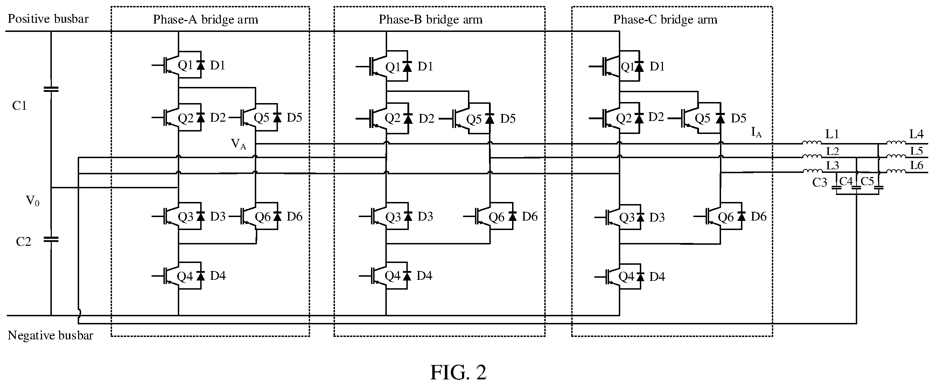

The power converter includes a power conversion circuit. FIG. 2 is a schematic of a topology of a three-phase power conversion circuit according to an embodiment of this application. The power conversion circuit in FIG. 2 may be applied to the foregoing PCS or photovoltaic inverter.

As shown in FIG. 2, the power conversion circuit includes a phase-A bridge arm, a phase-B bridge arm, a phase-C bridge arm, five capacitors, and six inductors. The power conversion circuit draws a current through a positive busbar and a negative busbar. A capacitor C1 and a capacitor C2 are connected in series between the positive busbar and the negative busbar. The capacitor C1 is connected to the positive busbar, and the capacitor C2 is connected to the negative busbar. After the current passes through the phase-A bridge arm, the phase-B bridge arm, and the phase-C bridge arm, currents are output through filter inductors L1, L2, and L3 respectively. After passing through capacitors C3, C4, and C5 respectively, the currents output by the phase-A bridge arm, the phase-B bridge arm, and the phase-C bridge arm through the filter inductors converge and flow into a series connection point of the capacitor C1 and the capacitor C2. After passing through inductors L4, L5, and L6 respectively, the currents output by the phase-A bridge arm, the phase-B bridge arm, and the phase-C bridge arm through the filter inductors supply power to a load.

In the power conversion circuit in FIG. 2, structures of the phase-A bridge arm, the phase-B bridge arm, and the phase-C bridge arm are similar. To avoid repetition, the following uses the phase-A bridge arm as an example for description. For structure descriptions of the phase-B bridge arm and the phase-C bridge arm, refer to the description of the phase-A bridge arm. The phase-A bridge arm includes an upper bridge arm, a lower bridge arm, and a bypass branch. The upper bridge arm includes switching transistors Q1 and Q2 that are connected in series, and Q1 is connected to the positive busbar. The lower bridge arm includes switching transistors Q3 and Q4 that are connected in series, and Q4 is connected to the negative busbar. The bypass branch includes Q5 and Q6 that are connected in series. Each switching transistor is connected in parallel to a diode. A conducting direction of the diode is opposite to a conducting direction of the switching transistor. Q5 in the bypass branch is connected to a series connection point of Q1 and Q2 in the upper bridge arm, Q6 in the bypass branch is connected to a series connection point of Q3 and Q4 in the lower bridge arm, Q2 in the upper bridge arm is connected in series to Q3 in the lower bridge arm, a series connection point of the upper bridge arm and the lower bridge arm is connected to the series connection point of the capacitor C1 and the capacitor C2, and a series connection point of Q5 and Q6 in the bypass branch is connected to L1. In this application, the switching transistor is turned on or turned off based on a drive signal input to the switching transistor.

In the power conversion circuit shown in FIG. 2, a voltage at the series connection point of the capacitor C1 and the capacitor C2 is V₀, and the series connection point of the capacitor C1 and the capacitor C2 is connected to a connection point of Q2 and Q3. One end of the capacitor C1 is connected to the positive busbar, the other end is connected to one end of C2, and the other end of C2 is connected to the negative busbar. A voltage of the positive busbar is U, and a voltage of the negative busbar is -U. The positive busbar is connected to a positive electrode of a direct current side of the power conversion circuit, and the negative busbar is connected to a negative electrode of the direct current side of the power conversion circuit.

In this embodiment of this application, based on different on/off states of the switching transistors, there may be three situations of an output voltage of the bridge arm in the power conversion circuit in a switching cycle. Specifically, when Q1 and Q5 in the upper bridge arm are turned on, and Q4 and Q6 in the lower bridge arm are turned off, a voltage value of an output voltage V_{A} of the bridge arm is U; when Q4 and Q6 in the lower bridge arm are turned on, and Q1 and Q5 in the upper bridge arm are turned off, the voltage value of the output voltage V_{A} of the bridge arm is -U; and when Q2 and Q5 in the upper bridge arm or Q3 and Q6 in the lower bridge arm are turned on, the voltage value of the output voltage V_{A} of the bridge arm is 0.

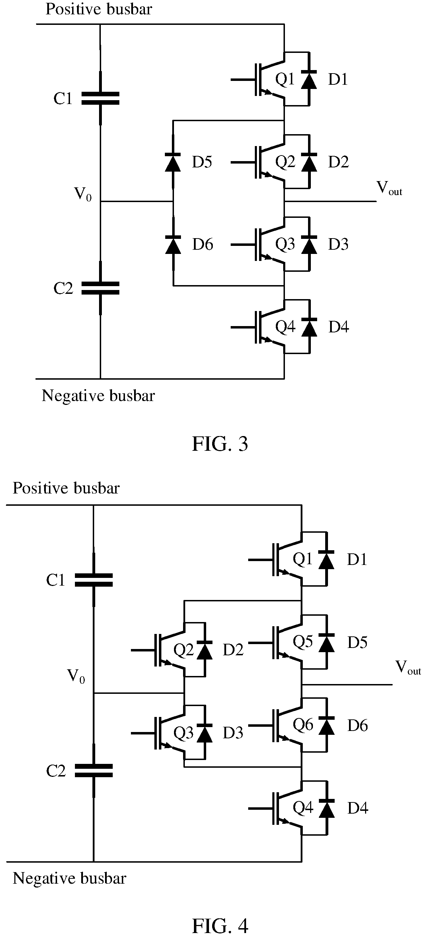

A topology of the power conversion circuit in FIG. 2 is merely an example, and the power conversion circuit in the power converter may alternatively have another topology structure, for example, topologies shown in FIG. 3 to FIG. 5. It should be noted that FIG. 3 to FIG. 5 show only topologies of single-phase inverter circuits. The technical solutions of this application may be applied to a single-phase power supply circuit, and may also be applied to a three-phase power supply circuit. Therefore, the topologies shown in FIG. 3 to FIG. 5 may be topologies of single-phase power supply circuits, or may be topologies of one-phase bridge arms in a three-phase power supply circuit. It may be understood that a circuit of each phase corresponds to one bridge arm.

In FIG. 3 to FIG. 5, based on turn-on and turn-off control of switching transistors, there may be three situations of an output voltage of the bridge arm in the power conversion circuit in a switching cycle.

As shown in FIG. 3, the power conversion circuit draws a current through a positive busbar and a negative busbar. A capacitor C1 and a capacitor C2 are connected in series between the positive busbar and the negative busbar. One end of the capacitor C1 is connected to the positive busbar, the other end is connected to one end of C2, and the other end of C2 is connected to the negative busbar. The power conversion circuit includes an upper bridge arm, a lower bridge arm, and a bypass branch. The upper bridge arm includes switching transistors Q1 and Q2 that are connected in series, and Q1 is connected to the positive busbar. The lower bridge arm includes switching transistors Q3 and Q4 that are connected in series, and Q4 is connected to the negative busbar. The bypass branch includes diodes D5 and D6 that are connected in series. Each switching transistor is connected in parallel to a diode. A conducting direction of the diode is opposite to a conducting direction of the switching transistor. D5 in the bypass branch is connected to a series connection point of Q1 and Q2 in the upper bridge arm, D6 in the bypass branch is connected to a series connection point of Q3 and Q4 in the lower bridge arm, Q2 in the upper bridge arm is connected in series to Q3 in the lower bridge arm, D5 and D6 in the bypass branch are connected in series, and a series connection point of D5 and D6 is connected to a series connection point of the capacitor C1 and the capacitor C2. In this application, the switching transistor is turned on or turned off based on a drive signal input to the switching transistor.

In the circuit in FIG. 3, a voltage of the positive busbar is U, and a voltage of the negative busbar is - U. When Q1 and Q2 are turned on, and Q3 and Q4 are turned off, a voltage value of an output voltage Vₒᵤₜ is U; when Q3 and Q4 are turned on, and Q1 and Q2 are turned off, the voltage value of the output voltage Vₒᵤₜ is -U; and when Q1 and Q4 are turned off, and Q2 or Q3 is turned on, the voltage value of the output voltage Vₒᵤₜ is U.

As shown in FIG. 4, the power conversion circuit draws a current through a positive busbar and a negative busbar. A capacitor C1 and a capacitor C2 are connected in series between the positive busbar and the negative busbar. One end of the capacitor C1 is connected to the positive busbar, the other end is connected to one end of C2, and the other end of C2 is connected to the negative busbar. The power conversion circuit includes an upper bridge arm, a lower bridge arm, and a bypass branch. The upper bridge arm includes switching transistors Q1 and Q5 that are connected in series, and Q1 is connected to the positive busbar. The lower bridge arm includes switching transistors Q4 and Q6 that are connected in series, and Q4 is connected to the negative busbar. The bypass branch includes Q2 and Q3 that are connected in series. Each switching transistor is connected in parallel to a diode. A conducting direction of the diode is opposite to a conducting direction of the switching transistor. Q2 in the bypass branch is connected to a series connection point of Q1 and Q5 in the upper bridge arm, Q3 in the bypass branch is connected to a series connection point of Q4 and Q6 in the lower bridge arm, Q5 in the upper bridge arm is connected in series to Q6 in the lower bridge arm, and a series connection point of Q2 and Q3 in the bypass branch is connected to a series connection point of the capacitor C1 and the capacitor C2. In this application, the switching transistor is turned on or turned off based on a drive signal input to the switching transistor.

In the circuit in FIG. 4, a voltage of the positive busbar is U, and a voltage of the negative busbar is - U. When Q1 and Q5 in the upper bridge arm are turned on, and Q4 and Q6 in the lower bridge arm are turned off, a voltage value of an output voltage Vₒᵤₜ is U; when Q4 and Q6 in the lower bridge arm are turned on, and Q1 and Q5 in the upper bridge arm are turned off, the voltage value of the output voltage Vₒᵤₜ is -U; and when Q2 and Q5 in the upper bridge arm or Q3 and Q6 in the lower bridge arm are turned on, the voltage value of the output voltage Vₒᵤₜ is 0.

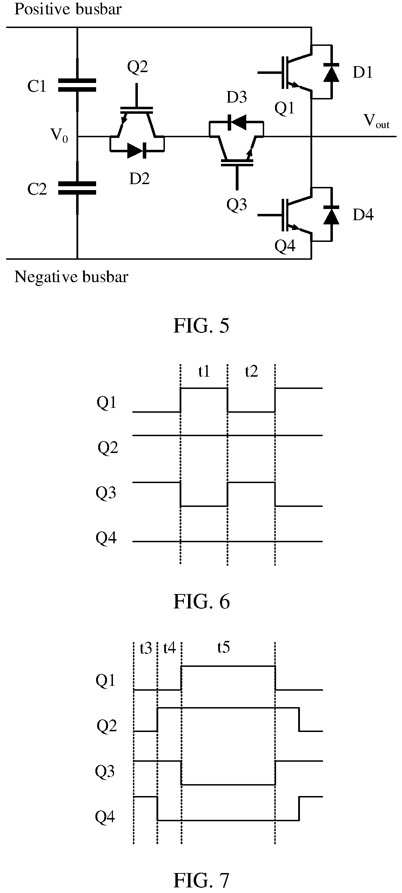

As shown in FIG. 5, the power conversion circuit draws a current through a positive busbar and a negative busbar. A capacitor C1 and a capacitor C2 are connected in series between the positive busbar and the negative busbar. One end of the capacitor C1 is connected to the positive busbar, the other end is connected to one end of C2, and the other end of C2 is connected to the negative busbar. The power conversion circuit includes an upper bridge arm, a lower bridge arm, and a bypass branch. The upper bridge arm includes a switching transistor Q1, and Q1 is connected to the positive busbar. The lower bridge arm includes a switching transistor Q4, and Q4 is connected to the negative busbar. The bypass branch includes Q2 and Q3 that are connected in series. Each switching transistor is connected in parallel to a diode. A conducting direction of the diode is opposite to a conducting direction of the switching transistor. Q1 and Q4 are connected in series, Q3 in the bypass branch is connected to a series connection point of Q1 and Q4, and Q2 in the bypass branch is connected to a series connection point of the capacitor C1 and the capacitor C2. In this application, the switching transistor is turned on or turned off based on a drive signal input to the switching transistor.

In the circuit in FIG. 5, a voltage of the positive busbar is U, and a voltage of the negative busbar is - U. When Q1 is turned on, and Q2, Q3, and Q4 are turned off, a voltage value of an output voltage Vₒᵤₜ is U; when Q4 is turned on, and Q1, Q2, and Q3 are turned off, the voltage value of the output voltage Vₒᵤₜ is -U; and when Q2 and Q3 are turned on, and Q1 and Q4 are turned off, the voltage value of the output voltage Vₒᵤₜ is 0.

It should be understood that the switching transistor in FIG. 2 to FIG. 5 may be an insulated gate bipolar transistor IGBT, a field-effect transistor MOSFET, or another controlled switch.

It should be noted that there are three situations of a voltage output by the bridge arm of the power converter in this embodiment of this application in a switching cycle. In actual use, a modulation method may be used to enable the bridge arm of the power converter to output different levels to obtain a step wave through combination, to approximate a sinusoidal output voltage, where each level corresponds to one output voltage. The modulation method in this embodiment of this application mainly includes unipolar modulation and bipolar modulation.

Bipolar modulation: A full name is bipolar pulse width modulation (pulse width modulation, PWM). Bipolar modulation means that a level output by the bridge arm in a switching cycle includes a co-directional level, a reverse level, and a zero level, where the zero level corresponds to a zero voltage, a polarity or a direction of a voltage corresponding to the forward level is the same as a polarity or a direction of an equivalent voltage output by the power conversion circuit, and a polarity or a direction of a voltage corresponding to the reverse level is opposite to the polarity or the direction of the equivalent voltage output by the power conversion circuit. For example, when the equivalent voltage output by the power conversion circuit is a positive voltage, the co-directional level is a positive level, and the reverse level is a negative level; and when the equivalent voltage output by the power conversion circuit is a negative voltage, the co-directional level is a negative level, and the reverse level is a positive level. In a bipolar modulation process, the bridge arm outputs three levels in a switching cycle. Therefore, bipolar modulation is also referred to as three-level modulation.

Unipolar modulation: A full name is unipolar PWM modulation. Unipolar modulation means that a level output by the bridge arm in a switching cycle includes only the co-directional level and the zero level, and does not include the reverse level. For example, when the equivalent voltage output by the power conversion circuit is a voltage of a positive half cycle of a sinusoidal voltage, the bridge arm outputs a positive level and a zero level under unipolar modulation; and when the equivalent voltage output by the power conversion circuit is a voltage of a negative half cycle of the sinusoidal voltage, the bridge arm outputs a negative level and a zero level under unipolar modulation. In a unipolar modulation process, the bridge arm outputs only two levels in a switching cycle. Therefore, unipolar modulation is also referred to as two-level modulation.

The following uses the circuit topology in FIG. 3 as an example to describe in detail processes of unipolar modulation and bipolar modulation with reference to sequence diagrams in FIG. 6 and FIG. 7.

FIG. 6 is a sequence diagram of a switching transistor on a bridge arm during unipolar modulation according to an embodiment of this application.

It should be understood that a high level indicates that the switching transistor is turned on, and a low level indicates that the switching transistor is turned off. Q1 to Q4 in FIG. 6 correspond to Q1 to Q4 in the circuit topology in FIG. 3. According to the sequence diagram in FIG. 6, Q2 is always turned on, and Q4 is always turned off. When Q1 is turned on within duration t1, and Q3 is turned off within the duration t1, a positive busbar current is output to a load through Q1 and Q2, and the bridge arm outputs a co-directional level. When Q1 is turned off within duration t2, and Q3 is turned on within the duration t2, there is no path on the positive busbar and the negative busbar, and the bridge arm outputs a zero level.

It should be understood that time lengths of t1 and t2 may be adjusted based on a requirement, and a sum of t1 and t2 is less than or equal to duration of one switching cycle.

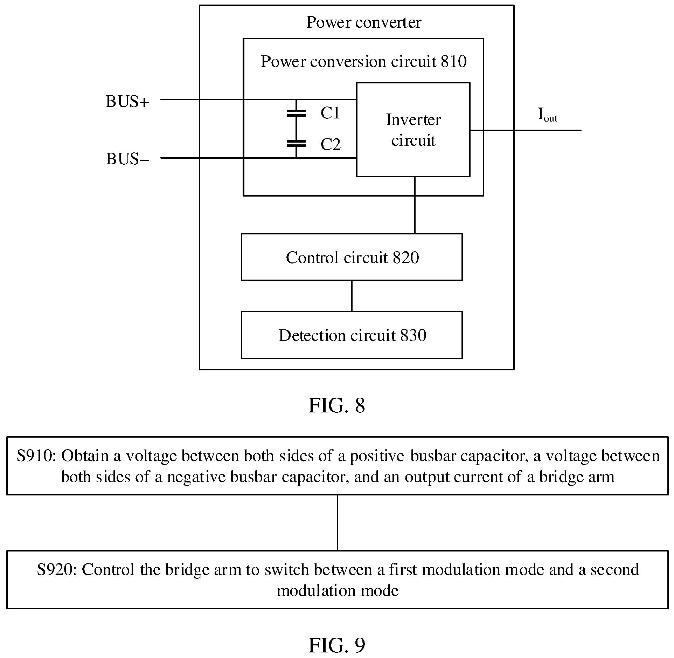

A control circuit 620 may further implement bipolar modulation on the bridge arm by using a drive signal input to each switching transistor on the bridge arm. The schematic of the circuit topology in FIG. 3 is used as an example. For a sequence diagram of the switching transistor during bipolar modulation performed by using the drive signal to control the switching transistor, refer to FIG. 8.

FIG. 7 is a sequence diagram of a switching transistor on a bridge arm during bipolar modulation according to an embodiment of this application.

It should be understood that a high level indicates that the switching transistor is turned on, and a low level indicates that the switching transistor is turned off. It should be understood that a high level indicates that the switching transistor is turned on, and a low level indicates that the switching transistor is turned off. Q1 to Q4 in FIG. 7 correspond to Q1 to Q4 in the circuit topology in FIG. 3. According to the sequence diagram in FIG. 7, within duration t3, Q1 and Q2 in FIG. 3 are turned off, Q3 and Q4 in FIG. 3 are turned on, a negative busbar current is output to a load through Q4 and Q3, and the bridge arm outputs a reverse level. Within duration t4, Q1 and Q4 are turned off, Q2 and Q3 are turned on, there is no path on the positive busbar and the negative busbar, and the bridge arm outputs a zero level. Within duration t5, Q1 and Q2 are turned on, Q3 and Q4 are turned off, a positive busbar current is output to the load through Q1 and Q2, and the bridge arm outputs a co-directional level.

It should be understood that time lengths of t3, t4, and t5 may be adjusted based on a requirement, and a sum of t3, t4, and t5 is less than or equal to duration of one switching cycle.

It should be noted that FIG. 6 and FIG. 7 are examples of switching transistor sequence diagrams provided for an output level of the circuit topology in FIG. 3. The switching transistor sequence diagrams may vary according to different topologies.

In this application, the power conversion circuit may combine a plurality of levels into a step wave to approximate a sinusoidal output voltage. When a zero level is output, a middle point voltage V₀ of the power conversion circuit is unbalanced, and consequently, voltages of the positive busbar and the negative busbar are unbalanced. When bipolar modulation is used, the power conversion circuit has one more output level than unipolar modulation. A PWM wave output by the power conversion circuit is closer to a sine waveform, ripple content is less, and quality of an output alternating current is better. In addition, when bipolar modulation is used, the bridge arm needs to output three levels in one switching cycle, so that duration of the zero level may be reduced, and impact on the voltages of the positive busbar and the negative busbar may be reduced. However, bipolar modulation causes an increase in power consumption due to frequent switching of the switching transistor on the bridge arm in the power converter. When unipolar modulation is used, although the increase in power consumption due to frequent switching of the switching transistor on the bridge arm in the power converter may be suppressed, the duration of the zero level is increased, and a degree of imbalance between positive and negative direct current busbar voltages is increased. In a serious case, the positive and negative direct current busbar voltages are significantly uneven, thereby affecting running efficiency of the power converter.

FIG. 6 and FIG. 7 are used as an example. For a same power converter, the following relationships should be met: $t 1 + t 2 = t 3 + t 4 + t 5$ $t 1 \times V 1 + t 2 \times V 2 = t 3 \times V 3 + t 4 \times V 2 + t 5 \times V 1$

V1 represents a voltage value of a forward level, V2 represents a voltage value (that is, 0) of a zero level, V3 represents a voltage value of a reverse level, t1 is duration of the forward level in FIG. 6, t2 is duration of the zero level in FIG. 6, t3 is duration of the reverse level in FIG. 7, t4 is duration of the zero level in FIG. 7, and t5 is duration of the forward level in FIG. 7. Formula (1) indicates that switching cycles are equal, and formula (2) indicates that equivalent voltages are equal. Assuming that V1 is a positive value, V3 is a negative value. It may be learned from formula (1) and formula (2) that t2 is greater than t4, that is, duration of the zero level during unipolar modulation is greater than duration of the zero level during bipolar modulation. Therefore, unipolar modulation increases the degree of imbalance between the positive and negative direct current busbar voltages. In a serious case, the positive and negative direct current busbar voltages are significantly uneven.

To reduce power consumption of the power converter when the degree of imbalance between the positive and negative direct current busbar voltages is within a tolerance range, this application provides the following power converter.

FIG. 8 shows a power converter according to an embodiment of this application.

As shown in FIG. 8, the power converter includes a power conversion circuit 810 and a control circuit 820. An input end of the power conversion circuit 810 is connected to a positive busbar and a negative busbar, that is, an input voltage of the power conversion circuit 810 is a positive busbar voltage BUS+ and a negative busbar voltage BUS-. The power conversion circuit 810 outputs a current Iₒᵤₜ to supply power to a load.

The power conversion circuit 810 includes an inverter circuit and a direct current busbar capacitor. The direct current busbar capacitor is connected in parallel to the inverter circuit. The direct current busbar capacitor is connected between the positive busbar and the negative busbar. The direct current busbar capacitor includes a positive busbar capacitor C1 and a negative busbar capacitor C2 that are connected in series. The positive busbar capacitor is configured to connect to the positive busbar, and the negative busbar capacitor is configured to connect to the negative busbar. The inverter circuit includes a plurality of bridge arms, output ends of the bridge arms are electrically connected to a filter circuit, each bridge arm includes a plurality of switching transistors, and the bridge arm is configured to convert an input direct current into an alternating current.

It should be noted that, in this embodiment of this application, a voltage output by the bridge arm is converted into a sinusoidal alternating current only after passing through the filter circuit, that is, the output end of the bridge arm is connected to the filter circuit. The output end of the bridge arm outputs a PWM waveform.

The power conversion circuit 810 may be a three-phase bridge arm, and a topology structure of a bridge arm of each phase of the power conversion circuit 810 may output three levels. The power conversion circuit 810 may alternatively be a single-phase bridge arm. A specific topology structure of the power conversion circuit 810 is not limited in this application. For example, a three-phase topology structure of the power conversion circuit 810 may be shown in FIG. 2, or the topology structure of the bridge arm of each phase of the power conversion circuit 810 may be shown in FIG. 3 to FIG. 5.

The control circuit 820 is configured to control, based on a voltage between both sides of the positive busbar capacitor, a voltage between both sides of the negative busbar capacitor, and an output current of the bridge arm, the bridge arm to switch between a first modulation mode and a second modulation mode.

In the first modulation mode, bipolar modulation is used for the bridge arm, that is, a level output by the bridge arm in one switching cycle includes a co-directional level, a zero level, and a reverse level. In the second modulation mode, unipolar modulation is used for the bridge arm, and a level output by the bridge arm in one switching cycle includes the co-directional level and the zero level. The co-directional level is a level in a direction that is the same as a direction of an equivalent voltage output by the inverter circuit, and the reverse level is a level in a direction that is opposite to the direction of the equivalent voltage output by the inverter circuit. If the equivalent voltage output by the inverter circuit in the switching cycle is a positive voltage, the co-directional level is a positive level, and the reverse level is a negative level; and if the equivalent voltage output by the inverter circuit in the switching cycle is a negative voltage, the co-directional level is a negative level, and the reverse level is a positive level.

It should be noted that, in an implementation scenario with a plurality of bridge arms, a modulation mode of each bridge arm is independently controlled. Therefore, the controlled bridge arm in this embodiment of this application is a corresponding bridge arm that meets a first condition or a second condition. For example, in a scenario with three bridge arms, if only a phase-A bridge arm meets the first condition, the phase-A bridge arm may be controlled to switch to the first modulation mode, and the other two phases may continue to work in the second modulation mode without switching. If both the phase-A bridge arm and a phase-B bridge arm meet the first condition, the phase-A bridge arm and the phase-B bridge arm may be controlled to switch to the first modulation mode, and a phase-C bridge arm may continue to work in the second modulation mode without switching.

Therefore, in this embodiment of this application, a situation of one of the bridge arms is mainly specifically described, and control logic of the other bridge arms is consistent. Details are not described again.

Specifically, if the control circuit 820 determines that a preset first condition is met, the control circuit 820 controls the bridge arm to switch from the second modulation mode to the first modulation mode; and if the control circuit 820 determines that the first condition is not met, the control circuit 820 controls the bridge arm to work in the second modulation mode.

In a possible implementation, the first condition represents a degree of imbalance between the positive and negative busbar voltages. To be specific, the control circuit 820 determines, based on the degree of imbalance between the positive and negative busbar voltages, whether the bridge arm works in the first modulation mode or the second modulation mode.

For example, the control circuit 820 determines the degree of imbalance between the positive and negative busbar voltages based on a difference between the voltage between both ends of the positive busbar capacitor and the voltage between both ends of the negative busbar capacitor and the output current of the bridge arm.

In a possible implementation, the first condition includes any one of the following conditions: ${V}_{+} - {V}_{-} \geq {V}_{limit 1} > 0 and 0 < {I}_{limit 1} \leq I \leq {I}_{limit 2} ;$ ${V}_{+} - {V}_{-} \geq {V}_{limit 1} > 0 and {I}_{limit 3} \leq I \leq {I}_{limit 4} < 0 ;$ ${V}_{+} - {V}_{-} \leq {V}_{limit 2} < 0 and 0 < {I}_{limit 1} \leq I \leq {I}_{limit 2} ; and$ ${V}_{+} - {V}_{-} \leq {V}_{limit 2} < 0 and {I}_{limit 3} \leq I \leq {I}_{limit 4} < 0 .$

*V*₊ represents the voltage between both ends of the positive busbar capacitor, *V*₋ represents the voltage between both ends of the negative busbar capacitor, I represents the output current of the bridge arm, *V*_{*limit*1} represents a preset first voltage threshold, *V*_{*limit*2} represents a preset second voltage threshold, *I*_{*limit*1} represents a preset first current threshold, *I*_{*limit*2} represents a preset second current threshold, *I*_{*limit*3} represents a preset third current threshold, and *I*_{*limit*4} represents a preset fourth current threshold.

If the first condition is met, it indicates that the degree of imbalance between the positive and negative busbar voltages exceeds a preset range, and the control circuit 820 determines, based on the degree of imbalance between the positive and negative busbar voltages, that the bridge arm works in the first modulation mode. Because three levels need to be output in the first modulation mode, duration of the zero level is reduced, and the degree of imbalance between the positive and negative busbar voltages is reduced. If the first condition is met, it indicates that the degree of imbalance between the positive and negative busbar voltages does not exceed the preset range, and the control circuit 820 determines, based on the degree of imbalance between the positive and negative busbar voltages, that the bridge arm works in the second modulation mode. Because only two levels need to be output in the second modulation mode, switching frequency of the switching transistors is relatively low, and power consumption may be reduced.

When the bridge arm works in the first modulation mode, duration of the three output levels may be different in different cases.

For example, when the condition 1 or the condition 2 is met, the difference between the voltage between both ends of the positive busbar capacitor and the voltage between both ends of the negative busbar capacitor is greater than or equal to the first voltage threshold, and to balance the busbar voltages, the positive busbar capacitor needs to be discharged, or the negative busbar capacitor needs to be charged. In the condition 1, the output current of the bridge arm is greater than or equal to the first current threshold and less than or equal to the second current threshold, that is, the bridge arm outputs a forward current, and the reverse level output by the bridge arm is a negative level, to charge the negative busbar capacitor. In the condition 2, the output current of the bridge arm is greater than or equal to the fourth current threshold and less than or equal to the third current threshold, that is, the bridge arm outputs a reverse current, and the reverse level output by the bridge arm is a positive level, to charge the positive busbar capacitor. Therefore, when the condition 2 is met, duration in which the bridge arm outputs the reverse level in one switching cycle needs to be reduced. For example, when the condition 1 is met, duration in which the bridge arm outputs the reverse level in one switching cycle is 0.2 times duration of the switching cycle; and when the condition 2 is met, the duration in which the bridge arm outputs the reverse level in one switching cycle is 0.1 times the duration of the switching cycle.

For example, when the condition 3 or the condition 4 is met, the difference between the voltage between both ends of the positive busbar capacitor and the voltage between both ends of the negative busbar capacitor is less than or equal to the second voltage threshold, and to balance the busbar voltages, the positive busbar capacitor needs to be charged, or the negative busbar capacitor needs to be discharged. In the condition 3, the output current of the bridge arm is greater than or equal to the first current threshold and less than or equal to the second current threshold, that is, the bridge arm outputs a forward current, and the reverse level output by the bridge arm is a negative level, to discharge the positive busbar capacitor. In the condition 4, the output current of the bridge arm is greater than or equal to the fourth current threshold and less than or equal to the third current threshold, that is, the bridge arm outputs a reverse current, and the reverse level output by the bridge arm is a positive level, to charge the positive busbar capacitor. Therefore, when the condition 3 is met, duration in which the bridge arm outputs the reverse level in one switching cycle needs to be reduced. For example, when the condition 3 is met, duration in which the bridge arm outputs the reverse level in one switching cycle is 0.1 times duration of the switching cycle; and when the condition 4 is met, the duration in which the bridge arm outputs the reverse level in one switching cycle is 0.2 times the duration of the switching cycle.

In a possible implementation, when the condition 2 is met, the duration in which the bridge arm outputs the reverse level in one switching cycle may be directly reduced to zero, and this is equivalent to that the bridge arm works in the second modulation mode. Similarly, when the condition 3 is met, the duration in which the bridge arm outputs the reverse level in one switching cycle may be directly reduced to zero, and this is equivalent to that the bridge arm works in the second modulation mode. In this case, the first condition includes the condition 1 and the condition 4.

It should be noted that the first voltage threshold, the second voltage threshold, the first current threshold, the second current threshold, the third current threshold, and the fourth current threshold may be determined based on tolerance to the degree of imbalance between the positive and negative busbar voltages. The tolerance to the degree of imbalance between the positive and negative busbar voltages may be different in different scenarios. Absolute values of the first voltage threshold and the second voltage threshold may be the same or different, absolute values of the first current threshold and the third current threshold may be the same or different, and absolute values of the second current threshold and the fourth current threshold may be the same or different. This is not limited in this application.

In a possible implementation, if the control circuit 820 determines that a preset second condition is met, the control circuit 820 controls the bridge arm to work in the first modulation mode; and if the control circuit 820 determines that the second condition is not met, the control circuit 820 controls the bridge arm to work in the second modulation mode. The second condition includes any one of the following conditions: ${V}_{+} - {V}_{-} \geq {V}_{limit 3} > 0 and 0 < {I}_{limit 5} \leq I \leq {I}_{limit 6} ;$ and ${V}_{+} - {V}_{-} \leq {V}_{limit 4} < 0 and {I}_{limit 7} \leq I \leq {I}_{limit 8} < 0 .$

*V*₊ represents the voltage between both ends of the positive busbar capacitor, *V*₋ represents the voltage between both ends of the negative busbar capacitor, I represents the output current of the bridge arm, *V*_{*limit*3} represents a preset third voltage threshold, *V*_{*limit*4} represents a preset fourth voltage threshold, *I*_{*limit*6} represents a preset fifth current threshold, *I*_{*limit*6} represents a preset sixth current threshold, *I_{límít7}* represents a preset seventh current threshold, and *I*_{*limit*8} represents a preset eighth current threshold.

The third voltage threshold, the fourth voltage threshold, the fifth current threshold, the sixth current threshold, the seventh current threshold, and the eighth current threshold may be determined based on tolerance to the degree of imbalance between the positive and negative busbar voltages. The tolerance to the degree of imbalance between the positive and negative busbar voltages may be different in different scenarios. Absolute values of the third voltage threshold and the fourth voltage threshold may be the same or different, absolute values of the fifth current threshold and the seventh current threshold may be the same or different, and absolute values of the sixth current threshold and the eighth current threshold may be the same or different. This is not limited in this application.

In this application, the control circuit 820 may obtain the difference between the voltage of the positive busbar capacitor and the voltage of the negative busbar capacitor and the output current of the bridge arm.

For example, the power converter further includes a detection circuit 830. The detection circuit 830 is connected to both sides of the positive busbar capacitor, both sides of the negative busbar capacitor, and the output end of the bridge arm in the power conversion circuit 810. The detection circuit 830 may be an internal module located in the control circuit 820, or may be an independent unit independent of the control circuit 820. This is not limited in this application. The detection circuit 830 may be an internal module located in the power conversion circuit 810, or may be an independent unit independent of the power conversion circuit 810. This is not limited in this application.

In this application, the control circuit may control the bridge arm to output three levels and two levels in a hybrid manner. When a degree of imbalance between the positive and negative busbars of the circuit is very high, three levels are output, to reduce the duration of the zero level, suppress imbalance between the positive and negative busbars, and improve electric energy output quality. When the degree of imbalance between the positive and negative busbars of the circuit is within a tolerance range, two levels are output, to reduce the switching frequency of the switching transistors, and reduce power consumption of the power converter. The voltage difference between the positive busbar capacitor and the negative busbar capacitor and the output current of the bridge arm are considered, so that a balance may be achieved between electric energy quality and power consumption, a balance of a middle point voltage may be maintained, and stability of the power converter may be improved.

In this application, the control circuit 820 may control, by using a drive signal input to each switching transistor on the bridge arm, the bridge arm to output different levels. When the switching transistor is controlled by using the drive signal, so that the bridge arm outputs two levels in one switching cycle, for a sequence diagram of the switching transistor, refer to FIG. 6. When the switching transistor is controlled by using the drive signal, so that the bridge arm outputs three levels in one switching cycle, for a sequence diagram of the switching transistor, refer to FIG. 7.

FIG. 9 is a diagram of a control method according to an embodiment of this application. The control method may be applied to the power converter in FIG. 8.

As shown in FIG. 9, S910: Obtain a voltage between both sides of a positive busbar capacitor, a voltage between both sides of a negative busbar capacitor, and an output current of a bridge arm.

For example, the voltage between both sides of the positive busbar capacitor, the voltage between both sides of the negative busbar capacitor, and the output current of the bridge arm may be obtained from a detection unit, and the detection unit is configured to detect the voltage between both sides of the positive busbar capacitor, the voltage between both sides of the negative busbar capacitor, and the output current of the bridge arm.

S920: Control, based on the voltage between both sides of the positive busbar capacitor, the voltage between both sides of the negative busbar capacitor, and the output current of the bridge arm, the bridge arm to switch between a first modulation mode and a second modulation mode. In the first modulation mode, a level output by the bridge arm in one switching cycle includes a co-directional level, a zero level, and a reverse level. In the second modulation mode, a level output by the bridge arm in one switching cycle includes the co-directional level and the zero level. The co-directional level is a level in a direction that is the same as a direction of an equivalent voltage output by an inverter circuit, and the reverse level is a level in a direction that is opposite to the direction of the equivalent voltage output by the inverter circuit. For a condition for using the first modulation mode or the second modulation mode, refer to related descriptions in FIG. 8. Details are not described herein again.

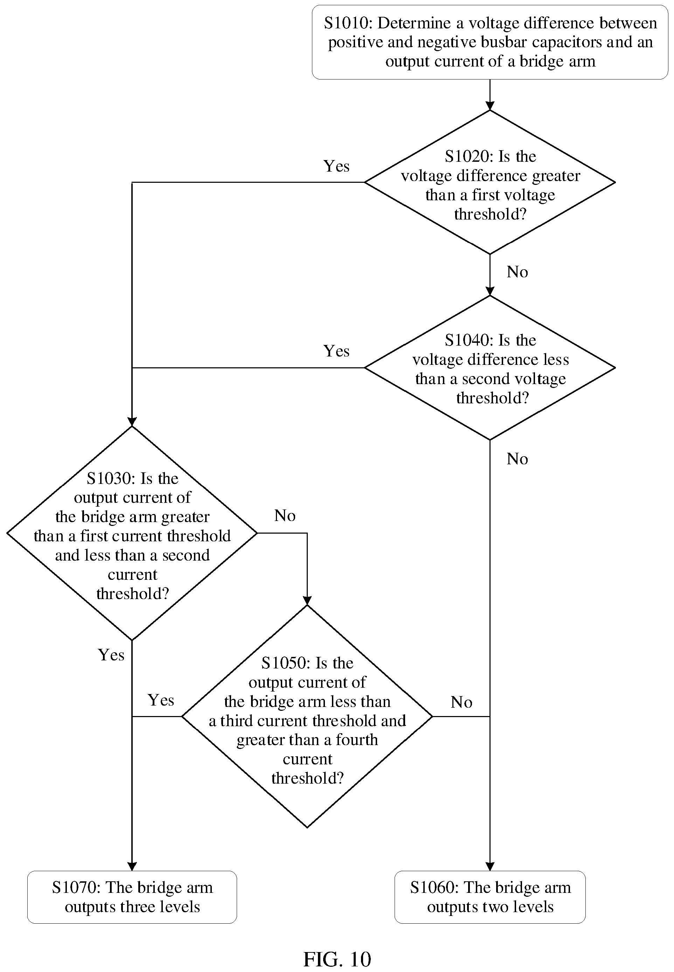

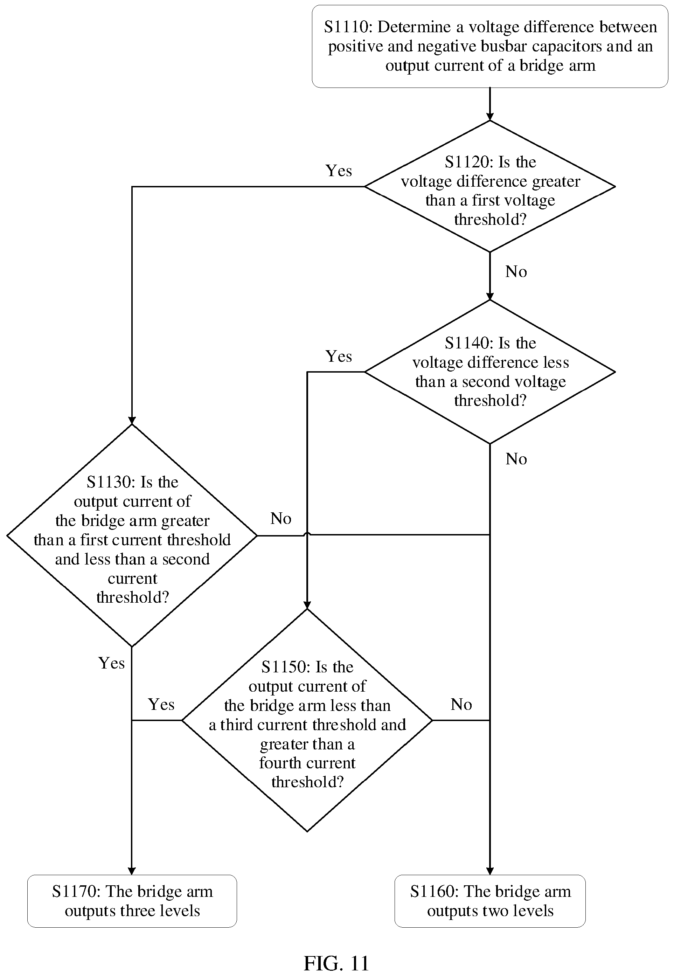

The following specifically describes switching logic of the first modulation mode and the second modulation mode with reference to logic diagrams in FIG. 10 and FIG. 11.

The following describes control logic of a control circuit with reference to FIG. 10 and FIG. 11.

FIG. 10 is a control logic diagram according to an embodiment of this application.

As shown in FIG. 10, a control circuit determines, based on a voltage difference between positive and negative busbar capacitors and an output current of a bridge arm in a power conversion circuit, whether a degree of imbalance between positive and negative busbar voltages exceeds a preset range.

S1010: The control circuit determines the voltage difference between the positive and negative busbar capacitors and the output current of the bridge arm in the power conversion circuit, and then determines an output level based on the voltage difference between the positive and negative busbar capacitors and the output current of the bridge arm in the power conversion circuit.

S1020: Determine whether the voltage difference between the positive and negative busbar capacitors is greater than a first voltage threshold; and if the voltage difference between the positive and negative busbar capacitors is greater than the first voltage threshold, perform S1030; or if the voltage difference between the positive and negative busbar capacitors is not greater than the first voltage threshold, perform S1040, where the first voltage threshold is a positive value.

S1030: Determine whether the output current of the bridge arm is greater than a first current threshold and less than a second current threshold; and if the output current of the bridge arm is greater than the first current threshold and less than the second current threshold, perform S1070; or if the output current of the bridge arm is not greater than the first current threshold or less than the second current threshold, perform S1050, where the first current threshold is less than the second current threshold, and the first current threshold is greater than or equal to zero.

S1040: Determine whether the voltage difference between the positive and negative busbar capacitors is less than a second voltage threshold; and if the voltage difference between the positive and negative busbar capacitors is less than the second voltage threshold, perform S1030; or if the voltage difference between the positive and negative busbar capacitors is not less than the second voltage threshold, perform S1060, where the second voltage threshold is a negative value.

S1050: Determine whether the output current of the bridge arm is less than a third current threshold and greater than a fourth current threshold; and if the output current of the bridge arm is less than the third current threshold and greater than the fourth current threshold, perform S1070; or if the output current of the bridge arm is not less than the third current threshold or greater than the fourth current threshold, perform S1060, where the third current threshold is greater than the fourth current threshold, and the third current threshold is less than or less than zero.

S1060: Control the bridge arm to output two levels in one switching cycle: a co-directional level and a zero level.

S1070: Control the bridge arm to output three levels in one switching cycle: a co-directional level, a zero level, and a reverse level.

It should be understood that a positive value and a negative value in this embodiment of this application indicate a direction of a voltage or a current. In this application, a direction that is the same as a positive busbar voltage direction is set to positive, and a direction that is opposite to the positive busbar voltage direction is set to negative.

It should be noted that the first voltage threshold, the second voltage threshold, the first current threshold, the second current threshold, the third current threshold, and the fourth current threshold may be determined based on tolerance to the degree of imbalance between the positive and negative busbar voltages. The tolerance to the degree of imbalance between the positive and negative busbar voltages may be different in different scenarios. Absolute values of the first voltage threshold and the second voltage threshold may be the same or different, absolute values of the first current threshold and the third current threshold may be the same or different, and absolute values of the second current threshold and the fourth current threshold may be the same or different. This is not limited in this application.

It should be noted that, in this embodiment of this application, the bridge arm may output three levels in one switching cycle under a plurality of conditions. However, in different cases, duration of each of the three levels output by the bridge arm in one switching cycle may be different. For example, when the voltage difference between the positive and negative busbar capacitors is greater than the first voltage threshold, duration of the reverse level output by the bridge arm when the output current of the bridge arm is greater than the first current threshold and less than the second current threshold is greater than duration of the reverse level output by the bridge arm when the output current of the bridge arm is less than the third current threshold and greater than the fourth current threshold, thereby ensuring that the negative busbar capacitor may be charged or the positive busbar capacitor may be discharged, to reduce a degree of imbalance between positive and negative busbars. When the voltage difference between the positive and negative busbar capacitors is less than the second voltage threshold, duration of the reverse level output by the bridge arm when the output current of the bridge arm is greater than the first current threshold and less than the second current threshold is less than duration of the reverse level output by the bridge arm when the output current of the bridge arm is less than the third current threshold and greater than the fourth current threshold, thereby ensuring that the positive busbar capacitor may be charged or the negative busbar capacitor may be discharged, to reduce the degree of imbalance between the positive and negative busbars.

FIG. 11 is another control logic diagram according to an embodiment of this application.

As shown in FIG. 11, S1110: A control circuit determines a voltage difference between positive and negative busbar capacitors and an output current of a bridge arm in a power conversion circuit, and then determines an output level based on the voltage difference between the positive and negative busbar capacitors and the output current of the bridge arm in the power conversion circuit.

S1120: Determine whether the voltage difference between the positive and negative busbar capacitors is greater than a third voltage threshold; and if the voltage difference between the positive and negative busbar capacitors is greater than the third voltage threshold, perform S1130; or if the voltage difference between the positive and negative busbar capacitors is not greater than the third voltage threshold, perform S1140, where the third voltage threshold is a positive value.

S1130: Determine whether the output current of the bridge arm is greater than a fifth current threshold and less than a sixth current threshold; and if the output current of the bridge arm is greater than the fifth current threshold and less than the sixth current threshold, perform S1170; or if the output current of the bridge arm is not greater than the fifth current threshold or less than the sixth current threshold, perform S1160, where the fifth current threshold and the sixth current threshold are positive values.

S1140: Determine whether the voltage difference between the positive and negative busbar capacitors is less than a fourth voltage threshold; and if the voltage difference between the positive and negative busbar capacitors is less than the fourth voltage threshold, perform S1150; or if the voltage difference between the positive and negative busbar capacitors is not less than the fourth voltage threshold, perform S1160, where the fourth voltage threshold is a negative value.

S1150: Determine whether the output current of the bridge arm is less than a seventh current threshold and greater than an eighth current threshold; and if the output current of the bridge arm is less than the seventh current threshold and greater than the eighth current threshold, perform S1170; or if the output current of the bridge arm is not less than the seventh current threshold or greater than the eighth current threshold, perform S1160, where the seventh current threshold and the eighth current threshold are negative values.

S1160: Control the bridge arm to output two levels in one switching cycle: a co-directional level and a zero level.

S1170: Control the bridge arm to output three levels in one switching cycle: a co-directional level, a zero level, and a reverse level.

It should be understood that a positive value and a negative value in this embodiment of this application indicate a direction of a voltage or a current. In this application, a direction that is the same as a positive busbar voltage direction is set to positive, and a direction that is opposite to the positive busbar voltage direction is set to negative.

In FIG. 11, compared with FIG. 10, when the voltage difference between the positive and negative busbar capacitors is greater than a positive value and the output current of the bridge arm is a negative value, or when the voltage difference between the positive and negative busbar capacitors is less than a negative value and the output current of the bridge arm is a positive value, duration of the output reverse level is reduced to zero, and the control circuit controls the bridge arm to output two levels instead of three levels, thereby reducing switching frequency of a switching transistor and reducing power consumption when ensuring that a balance between positive and negative busbars may be achieved.

By using the control logic in FIG. 10 or FIG. 11, the control circuit in FIG. 6 may reduce duration of a zero level when three levels are output, and maintain stability of a middle point voltage between a positive busbar capacitor and a negative busbar capacitor, so that a power conversion apparatus may stably output high-quality alternating current electric energy.

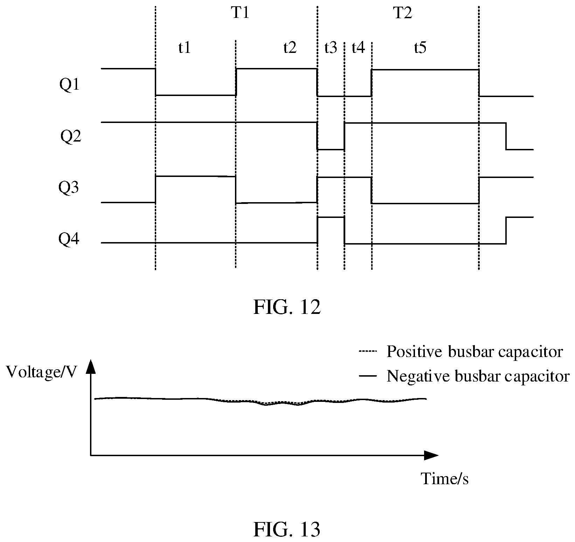

FIG. 12 is a sequence diagram of hybrid control of unipolar modulation and bipolar modulation used by the power conversion apparatus in FIG. 6. The power conversion apparatus in FIG. 6 uses the circuit topology in FIG. 3.

In a cycle T1, Q2 in FIG. 3 is always turned on, and Q4 is always turned off. When Q1 is turned off within duration t1, and Q3 is turned on within the duration t1, there is no path on a positive busbar and a negative busbar, and a bridge arm outputs a zero level. When Q1 is turned on within duration t2, and Q3 is turned off within the duration t2, a positive busbar current is output to a load through Q1 and Q2, and the bridge arm outputs a co-directional level. In this case, unipolar modulation is used.

In a cycle T2, Q1 and Q2 in FIG. 3 are turned off within duration t3, Q3 and Q4 are turned on within the duration t3, a negative busbar current is output to the load through Q4 and Q3, and the bridge arm outputs a reverse level. Q1 and Q4 are turned off within duration t4, Q2 and Q3 are turned on within the duration t4, there is no path on the positive busbar and the negative busbar, and the bridge arm outputs a zero level. Q1 and Q2 are turned on within duration t5, Q3 and Q4 are turned off within the duration t5, a positive busbar current is output to the load through Q1 and Q2, and the bridge arm outputs a co-directional level. In this case, unipolar modulation is used.

FIG. 13 is a diagram of voltages of a positive busbar capacitor and a negative busbar capacitor according to an embodiment of this application. It may be learned from FIG. 13 that a voltage difference (a middle point voltage) between the positive busbar capacitor and the negative busbar capacitor may be kept almost zero by using this application, thereby ensuring that a power conversion apparatus may stably output high-quality electric energy.

It should be noted that the power converter in this application may be used in many scenarios. This is not limited in this application. For example, in a photovoltaic power generation scenario, the power converter may correspond to a photovoltaic inverter.

An embodiment of this application further provides a power supply system, including a power supply and a power converter. For the power converter, refer to the description of the power converter in FIG. 6. Details are not described herein again. The power supply may include an energy storage apparatus and/or a photovoltaic power generation device. For example, the energy storage apparatus may include one or more of an energy storage cabinet, a battery, a battery pack, and a battery cluster, and the photovoltaic power generation device may include a photovoltaic panel.

Optionally, the power supply system may further include a positive busbar, a negative busbar, and a transformer. The power supply is connected to a positive input end of the power converter by using the positive busbar, and is connected to a negative input end of the power converter by using the negative busbar. The power converter is configured to convert a direct current input by the power supply into an alternating current. The transformer is configured to perform voltage transformation on the alternating current output by the power converter, and output a transformed alternating current to a load.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for indicating a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, wherein a positive electrode of a direct current side of the power converter is configured to connect to a positive direct current busbar, a negative electrode of the direct current side is configured to connect to a negative direct current busbar, and the power converter comprises a power conversion circuit, a filter circuit, and a control circuit;
the power conversion circuit comprises an inverter circuit and a direct current busbar capacitor, the direct current busbar capacitor is connected between the positive direct current busbar and the negative direct current busbar, and the direct current busbar capacitor comprises a positive busbar capacitor and a negative busbar capacitor that are connected in series;
the inverter circuit comprises a bridge arm, an output end of the bridge arm is electrically connected to the filter circuit, the bridge arm comprises a plurality of switching transistors, and the bridge arm is configured to convert an input direct current into an alternating current; and
the control circuit is configured to control, based on a voltage between both sides of the positive busbar capacitor, a voltage between both sides of the negative busbar capacitor, and an output current of the bridge arm, the bridge arm to switch between a first modulation mode and a second modulation mode, wherein
in the first modulation mode, a level output by any bridge arm in one switching cycle comprises a co-directional level, a zero level, and a reverse level; and
in the second modulation mode, a level output by any bridge arm in one switching cycle comprises the co-directional level and the zero level, wherein
the co-directional level is a level in a direction that is the same as a direction of an equivalent voltage output by the inverter circuit, and the reverse level is a level in a direction that is opposite to the direction of the equivalent voltage output by the inverter circuit.

2. The power converter according to claim 1, wherein the control circuit is specifically configured to:
in response to a preset condition being met, control the bridge arm to switch from the second modulation mode to the first modulation mode, wherein
the preset condition comprises any one of the following conditions: ${V}_{+} - {V}_{-} \geq {V}_{limit 1} > 0 and 0 < {I}_{limit 1} \leq I \leq {I}_{limit 2} ;$ ${V}_{+} - {V}_{-} \geq {V}_{limit 1} > 0 and {I}_{limit 3} \leq I \leq {I}_{limit 4} < 0 ;$ ${V}_{+} - {V}_{-} \leq {V}_{limit 2} < 0 and 0 < {I}_{limit 1} \leq I \leq {I}_{limit 2} ;$ and ${V}_{+} - {V}_{-} \leq {V}_{limit 2} < 0 and {I}_{limit 3} \leq I \leq {I}_{limit 4} < 0 ,$ wherein
*V*₊ represents the voltage between both ends of the positive busbar capacitor, *V*₋ represents the voltage between both ends of the negative busbar capacitor, I represents the output current of the bridge arm, *V*_{*limit*1} represents a preset first voltage threshold, *V*_{*limit*2} represents a preset second voltage threshold, *I*_{*limit*1} represents a preset first current threshold, *I*_{*limit*2} represents a preset second current threshold, *I*_{*limit*3} represents a preset third current threshold, and *I*_{*limit*4} represents a preset fourth current threshold.

3. The power converter according to claim 2, wherein in the first modulation mode: ${t}_{1} > {t}_{2} ;$ and ${t}_{3} < {t}_{4} ,$ wherein
*t*₁ represents duration in which the bridge arm outputs the reverse level in one switching cycle when the condition 1 is met, *t*₂ represents duration in which the bridge arm outputs the reverse level in one switching cycle when the condition 2 is met, *t*₃ represents duration in which the bridge arm outputs the reverse level in one switching cycle when the condition 3 is met, and *t*₄ represents duration in which the bridge arm outputs the reverse level in one switching cycle when the condition 4 is met.

4. The power converter according to claim 1, wherein the control circuit is specifically configured to:
in response to a preset condition being met, control the bridge arm to switch from the second modulation mode to the first modulation mode, wherein
the preset condition comprises any one of the following conditions: ${V}_{+} - {V}_{-} \geq {V}_{limit 3} > 0 and 0 < {I}_{limit 5} \leq I \leq {I}_{limit 6} ;$ and ${V}_{+} - {V}_{-} \leq {V}_{limit 4} < 0 and {I}_{limit 7} \leq I \leq {I}_{limit 8} < 0 ,$ wherein
*V*₊ represents the voltage between both ends of the positive busbar capacitor, *V*₋ represents the voltage between both ends of the negative busbar capacitor, I represents the output current of the bridge arm, *V*_{*limit*3} represents a preset third voltage threshold, *V*_{*limit*4} represents a preset fourth voltage threshold, *I*_{*limit*6} represents a preset fifth current threshold, *I*_{*limit*6} represents a preset sixth current threshold, *I_{límít7}* represents a preset seventh current threshold, and *I*_{*limit*8} represents a preset eighth current threshold.

5. The power converter according to any one of claims 1 to 4, wherein the power converter further comprises:
a detection circuit, wherein the detection circuit is configured to detect the voltage between both sides of the positive busbar capacitor, the voltage between both sides of the negative busbar capacitor, and the output current of the bridge arm.

6. A control method, applied to a power converter, wherein a positive electrode of a direct current side of the power converter is configured to connect to a positive direct current busbar, a negative electrode of the direct current side is configured to connect to a negative direct current busbar, and the power converter comprises a power conversion circuit, a filter circuit, and a control circuit; the power conversion circuit comprises an inverter circuit and a direct current busbar capacitor, the direct current busbar capacitor is connected between the positive direct current busbar and the negative direct current busbar, and the direct current busbar capacitor comprises a positive busbar capacitor and a negative busbar capacitor that are connected in series; the inverter circuit comprises a bridge arm, an output end of the bridge arm is electrically connected to the filter circuit, the bridge arm comprises a plurality of switching transistors, and the bridge arm is configured to convert an input direct current into an alternating current; and
the method comprises:
obtaining a voltage between both sides of the positive busbar capacitor, a voltage between both sides of the negative busbar capacitor, and an output current of the bridge arm; and
controlling, based on the voltage between both sides of the positive busbar capacitor, the voltage between both sides of the negative busbar capacitor, and the output current of the bridge arm, the bridge arm to switch between a first modulation mode and a second modulation mode, wherein
in the first modulation mode, a level output by the bridge arm in one switching cycle comprises a co-directional level, a zero level, and a reverse level; and
in the second modulation mode, a level output by the bridge arm in one switching cycle comprises the co-directional level and the zero level, wherein
the co-directional level is a level in a direction that is the same as a direction of an equivalent voltage output by the inverter circuit, and the reverse level is a level in a direction that is opposite to the direction of the equivalent voltage output by the inverter circuit.

7. The control method according to claim 6, wherein the method comprises:
in response to a preset condition being met, controlling the bridge arm to switch from the second modulation mode to the first modulation mode, wherein
the preset condition comprises any one of the following conditions: ${V}_{+} - {V}_{-} \geq {V}_{limit 1} > 0 and 0 < {I}_{limit 1} \leq I \leq {I}_{limit 2} ;$ ${V}_{+} - {V}_{-} \geq {V}_{limit 1} > 0 and {I}_{limit 3} \leq I \leq {I}_{limit 4} < 0 ;$ ${V}_{+} - {V}_{-} \leq {V}_{limit 2} < 0 and 0 < {I}_{limit 1} \leq I \leq {I}_{limit 2} ;$ and ${V}_{+} - {V}_{-} \leq {V}_{limit 2} < 0 and {I}_{limit 3} \leq I \leq {I}_{limit 4} < 0 ,$ wherein
*V*₊ represents the voltage between both ends of the positive busbar capacitor, *V*₋ represents the voltage between both ends of the negative busbar capacitor, I represents the output current of the bridge arm, *V*_{*limit*1} represents a preset first voltage threshold, *V*_{*limit*2} represents a preset second voltage threshold, *I*_{*limit*1} represents a preset first current threshold, *I*_{*limit*2} represents a preset second current threshold, *I*_{*limit*3} represents a preset third current threshold, and *I*_{*limit*4} represents a preset fourth current threshold.

8. The control method according to claim 7, wherein in the first modulation mode: ${t}_{1} > {t}_{2} ;$ and ${t}_{3} < {t}_{4} ,$ wherein
*t*₁ represents duration in which the bridge arm outputs the reverse level in one switching cycle when the condition 1 is met, *t*₂ represents duration in which the bridge arm outputs the reverse level in one switching cycle when the condition 2 is met, *t*₃ represents duration in which the bridge arm outputs the reverse level in one switching cycle when the condition 3 is met, and *t*₄ represents duration in which the bridge arm outputs the reverse level in one switching cycle when the condition 4 is met.

9. The control method according to claim 6, wherein the method comprises:
in response to a preset condition being met, controlling the bridge arm to switch from the second modulation mode to the first modulation mode, wherein
the preset condition comprises any one of the following conditions: ${V}_{+} - {V}_{-} \geq {V}_{limit 3} > 0 and 0 < {I}_{limit 5} \leq I \leq {I}_{limit 6} ;$ and ${V}_{+} - {V}_{-} \leq {V}_{limit 4} < 0 and {I}_{limit 7} \leq I \leq {I}_{limit 8} < 0 ,$ wherein
*V*₊ represents the voltage between both ends of the positive busbar capacitor, *V*₋ represents the voltage between both ends of the negative busbar capacitor, I represents the output current of the bridge arm, *V*_{*limit*3} represents a preset third voltage threshold, *V*_{*limit*4} represents a preset fourth voltage threshold, *I*_{*limit*6} represents a preset fifth current threshold, *V*_{*limit*6} represents a preset sixth current threshold, *I_{límít7}* represents a preset seventh current threshold, and *I*_{*limit*8} represents a preset eighth current threshold.

10. The control method according to any one of claims 6 to 9, wherein the power converter further comprises a detection circuit, and the method further comprises:
obtaining, from the detection circuit, the voltage between both sides of the positive busbar capacitor, the voltage between both sides of the negative busbar capacitor, and the output current of the bridge arm, wherein the detection circuit is configured to detect the voltage between both sides of the positive busbar capacitor, the voltage between both sides of the negative busbar capacitor, and the output current of the bridge arm.

11. A power supply system, comprising:
a power supply, a positive busbar, a negative busbar, and at least one power converter according to any one of claims 1 to 5, wherein
the power supply is connected to a positive input end of the power converter by using the positive busbar, and is connected to a negative input end of the power converter by using the negative busbar; and
the power converter is configured to convert a direct current input by the power supply into an alternating current, and output the alternating current to a load.

12. The power supply system according to claim 11, wherein the power supply comprises a photovoltaic module and/or an energy storage device.
